# EUROPÄISCHE PATENTSCHRIFT

(11) **EP 0 337 258 B1**
(45) Veröffentlichungstag und Bekanntmachung des Hinweises auf die Patenterteilung: **23.06.1993**
(21) Anmeldenummer: 89105919.8
(22) Anmeldetag: 05.04.1989
(51) Int. Cl.: G03F 7/004

(54) **Strahlungsempfindliches Gemisch für lichtempfindliche Beschichtungsmaterialien und Verfahren zur Herstellung von Reliefmustern und Reliefbildern**
Light sensitive compositions for light sensitive coating materials and processes for obtaining relief patterns and images
Compositions photosensibles pour matériaux de revêtement photosensibles et procédé de fabrication d'images et de modèles formant relief

(30) Priorität: 14.04.1988 DE 3812325
(43) Veröffentlichungstag der Anmeldung: 18.10.1989
(73) Patentinhaber: BASF Aktiengesellschaft, 67063 Ludwigshafen (DE)
(72) Erfinder: Schwalm, Reinhold, D-6706 Wachenheim (DE)

(56) Entgegenhaltungen:
- EP-A- 0 132 710
- EP-A- 0 271 010
- EP-A- 0 297 443
- DE-A- 3 628 046
- JOURNAL OF IMAGING TECHNOLOGY. vol. 11, no. 4, August 1985, SPRINGFIELD US Seiten 146 - 157; S.Papas: "Photogeneration of Acid: Part 6 -A Review of Basic Principles for Resist"

## Beschreibung

Die Erfindung betrifft positiv arbeitende strahlungsempfindliche Gemische, die ein wäßrig-alkalisch lösliches Bindemittel sowie eine Verbindung, die mindestens eine durch Säure spaltbare Bindung enthält und unter Einwirkung von Strahlung eine starke Säure bildet, enthalten, wobei die Löslichkeit der Verbindung in einem alkalischen Lösungsmittel durch die Einwirkung der Säure erhöht wird. Diese Gemische sind sensitiv gegenüber UV-, Elektronen-und Röntgenstrahlen und eignen sich besonders zur Herstellung von Reliefmustern und Reliefbildern, insbesondere als Resistmaterialien.

Positiv arbeitende strahlungsempfindliche Gemische sind bekannt, und besonders positiv arbeitende Resistmaterialien, die o-Chinondiazide in wäßrig-alkalisch löslichen Bindemitteln, z.B. Novolaken, enthalten, werden kommerziell eingesetzt. Die Empfindlichkeit dieser Systeme gegenüber Strahlung, insbesondere kurzwelliger Strahlung, ist jedoch teilweise unbefriedigend. Dies ist teilweise auf die hohe Absorption der Novolake im kurzwelligen UV-Bereich zurückzuführen. Die wesentlich transparenteren Polymeren auf Basis von p-Hydroxystyrolen werden aber in T. Pampalone in "Solid State Technology, June 1984, Seiten 115-120" als weniger geeignet beschrieben, da sie einen unakzeptabel hohen Abtrag aufweisen.

Ebenfalls bekannt sind positiv arbeitende Einkomponentenresiste mit o-Nitrobenzylgruppierungen (vgl. DE-A-21 50 691, DE-A-29 22 746 und DE-A-36 42 184). Die Lichtempfindlichkeit dieser Copolymeren ist jedoch ebenso unbefriedigend.

Drastische Empfindlichkeitserhöhungen in strahlungsempfindlichen Systemen, die in der Primärfotoreaktion eine Spezies erzeugen, die dann unabhängig von der Strahlung eine katalytische Sekundärreaktion auslösen, sind ebenfalls bereits beschrieben. Aus US-A-3 923 514 und US-A-3 915 706 sind beispielsweise Photoinitiatoren bekannt, die eine starke Säure erzeugen, die dann in einer Sekundärreaktion säurelabile Gruppen, wie Polyaldehydgruppierungen spalten.

Strahlungsempfindliche Gemische von Polymeren mit säurelabilen Seitengruppen und fotochemischen Säurespendern sind z.B. aus US-A-4 491 628 und FR-A-2 570 844 bekannt. Diese polymeren Bindemittel sind jedoch hydrophob und werden erst nach der Belichtung alkalilöslich.

Weiterhin sind strahlungsempfindliche Gemische auf Basis von säurespaltbaren Verbindungen bekannt, die als Bindemittel ein wäßrig-alkalisch lösliches Polymer, sowie eine Verbindung, die fotochemisch eine starke Säure bildet, und eine weitere Verbindung mit durch Säure spaltbaren Bindungen, die durch die Einwirkung der Säure ihre Löslichkeit in einem alkalischen Entwickler erhöhen, enthalten (vgl. z.B. DE-A-3 406 927).

Als photochemisch eine starke Säure bildende Verbindungen werden Diazonium-, Phosphonium-, Sulfonium- und Iodonium-, sowie Halogenverbindungen genannt. Nachteilig bei diesen Photoinitiatoren ist, daß durch die Einwirkung der Strahlung überwiegend hydrophobe Photoprodukte erzeugt werden, die in alkalischen Entwicklern unlöslich sind.

Die Verwendung von Oniumsalzen als fotochemische Säurespender in Resistmaterialien ist z.B. aus der bereits erwähnten US-A-4 491 628 bekannt. Einen Überblick über die Anwendung in Resistmaterialien gibt Crivello in Org. Coatings and Appl. Polym. Sci., 48, p. 65-69 (1985).

In DE-A-37 21 740 werden Sulfoniumsalze vorgeschlagen, welche säurelabile Gruppierungen im Molekül enthalten und durch die Einwirkung der Strahlung so verändert werden, daß die Löslichkeit in alkalischen Entwicklern drastisch erhöht wird.

Aufgabe der vorliegenden Erfindung war es, hochreaktive strahlungsempfindliche Systeme für die Herstellung von Reliefstrukturen zur Verfügung zu stellen, die sich mit wäßrig-alkalischen Lösungen entwickeln lassen.

Es wurde nun gefunden, daß die oben genannten Systeme auf Basis von p-Hydroxystyrolpolymerisaten als Bindemittel, die einen hohen Abtrag im alkalischen Entwickler aufweisen, durch den Zusatz der hydrophoben o-Nitrobenzylesterkomponente in ihrer Alkalilöslichkeit (in einem Entwickler bestimmter Stärke) stark reduziert werden, wobei besonders vorteilhaft ist, daß die o-Nitrobenzylestergruppierungen bei der Belichtung in Carbonsäuren umgelagert werden und damit die belichteten Bereiche wieder alkalilöslich werden.

Die Alkalilöslichkeit in den belichteten Bereichen wird erfindungsgemäß sowohl über das Bindemittel, durch die fotochemische Erzeugung von Carbonsäure, als auch über die Umwandlung der als Löslichkeitsinhibitoren zugesetzten Sulfoniumsalze erhöht.

Gegenstand der vorliegenden Erfindung ist ein strahlungsempfindliches Gemisch, enthaltend
(a) ein in Wasser unlösliches, in wäßrig-alkalischen Lösungen lösliches polymeres Bindemittel und
(b) eine organische Verbindung, deren Löslichkeit in einem wäßrig-alkalischen Entwickler durch Einwirkung von Säure erhöht wird und die mindestens eine durch Säure spaltbare Gruppierung enthält,
das dadurch gekennzeichnet ist, daß das polymere Bindemittel (a) ein Copolymerisat ist, welches o-Nitrobenzylgruppierungen enthält, wobei das Bindemittel (a) vorzugsweise ein Copolymerisat ist, welches einpolymerisiert enthält
(a₁) 1 bis 40 Mol% mindestens einer Verbindung der allgemeinen Formel (I) 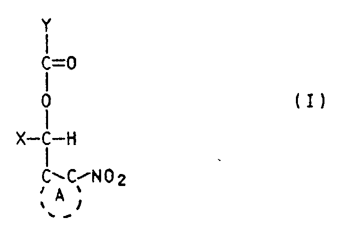 worin
   - A: für ein aromatisches oder heteroaromatisches, gegebenenfalls substituiertes Ringsystem mit 5 bis 14 Ringgliedern,
   - X: für Wasserstoff, einen Alkylrest mit 1 bis 8 Kohlenstoffatomen, einen gegebenenfalls substituierten Aryl- oder Aralkylrest und
   - Y: für einen ethylenisch ungesättigten Rest mit 2 bis 10 Kohlenstoffatomen
   stehen,
(a₂) 99 bis 60 Mol% mindestens einer Verbindung der allgemeinen Formel (II) 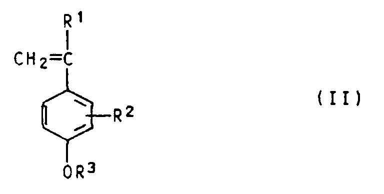 worin
   - R¹: für Wasserstoff oder eine Methylgruppe,
   - R²: für Wasserstoff, Halogen oder eine Alkylgruppe mit 1 bis 6 Kohlenstoffatomen,
   - R³: für Wasserstoff, eine Alkylgruppe mit 1 bis 6 Kohlenstoffatomen, eine Acetyl-, Benzoyl-, C₁- bis C₆-Alkylsilyl- oder C₁- bis C₆-Alkoxysilylgruppe stehen,
(a₃) 0 bis 20 Mol% einer oder mehrerer weiterer von (a₁) und (a₂) verschiedener olefinisch ungesättigter, copolymerisierbarer organischer Verbindungen, deren Homopolymerisate im Wellenlängenbereich zwischen 250 und 400 nm transparent sind,
mit der Maßgabe, daß die Summe der under (a₁) bis (a₃) genannten Mol-Prozentzahlen 100 ist.

Bevorzugt ist, daß das erfindungsgemäße strahlungsempfindliche Gemisch als Komponente (b) ein oder mehrere Sulfoniumsalze der allgemeinen Formel (III) 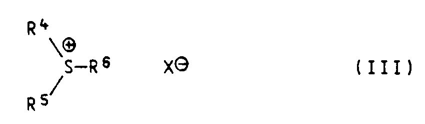
worin R⁴, R⁵ und R⁶ untereinander gleich oder verschieden sind und für aliphatische und/oder aromatische Reste, die gegebenenfalls Heteroatome enthalten, stehen oder zwei der Reste R⁴ bis R⁶ miteinander zu einem Ring verknüpft sind, mit der Maßgabe, daß mindestens einer der Reste R⁴ bis R⁶ mindestens eine durch Säure spaltbare Gruppierung enthält, wobei einer der Reste R⁴ bis R⁶ mit einem oder mehreren weiteren Sulfoniumsalzresten, gegebenenfalls über durch Säure spaltbare Gruppierungen, verknüpft sein kann, und X^{⊖} ein nichtnukleophiles Gegenion bedeutet, enthält.

Gegenstand der vorliegenden Erfindung ist außerdem ein Verfahren zur Herstellung von Reliefmustern und Reliefbildern, wobei als lichtempfindliche Beschichtungsmaterialien erfindungsgemäße strahlungsempfindliche Gemische verwendet werden, die vorteilhafterweise nach der Belichtung auf Temperaturen zwischen 60 und 120°C erhitzt werden.

Überraschenderweise erhält man mit dem erfindungsgemäßen strahlungsempfindlichen Gemisch Resistmuster guter Strukturqualität bei der Belichtung im kurzwelligen UV-Bereich, bevorzugt 248 nm, wobei die Photoempfindlichkeit des Gemisches sehr hoch ist und kein nennenswerter Abtrag der unbelichteten Bereiche während der erforderlichen Entwicklungszeiten auftritt.

Zu den Aufbaukomponenten des erfindungsgemäßen strahlungsempfindlichen Gemisches ist im einzelnen folgendes auszuführen.

Als polymere Bindemittel (a) kommen alle in Wasser unlöslichen, in wäßrigalkalischen Lösungen jedoch löslichen o-Nitrobenzylgruppierungen enthaltenden Polymersate, bevorzugt jedoch die Copolymerisate, die in DE-A-36 42 184 beschrieben sind, in Frage.

Bevorzugt sind dabei solche Copolymeren (a), welche einpolymerisiert enthalten
(a₁) 1 bis 40 Mol% mindestens einer Verbindung der allgemeinen Formel (I) 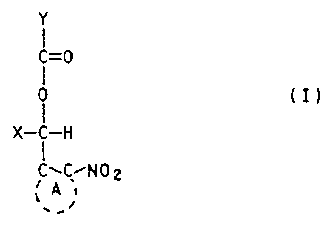 worin
   - A: für ein aromatisches oder heteroaromatisches, gegebenenfalls substituiertes Ringsystem mit 5 bis 14 Ringgliedern,
   - X: für Wasserstoff, einen Alkylrest mit 1 bis 8 Kohlenstoffatomen, einen gegebenenfalls substituierten Aryl- oder Aralkylrest und
   - Y: für einen ethylenisch ungesättigten Rest mit 2 bis 10 Kohlenstoffatomen
   stehen,
(a₂) 99 bis 60 Mol% mindestens einer Verbindung der allgemeinen Formel (II) 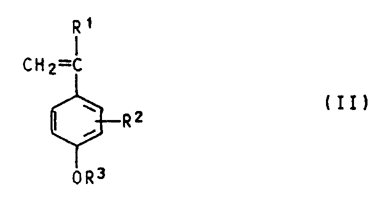 worin
   - R¹: für Wasserstoff oder eine Methylgruppe,
   - R²: für Wasserstoff, Halogen oder eine Alkylgruppe mit 1 bis 6 Kohlenstoffatomen,
   - R³: für Wasserstoff, eine Alkylgruppe mit 1 bis 6 Kohlenstoffatomen, eine Acetyl-, Benzoyl-, C₁- bis C₆-Alkylsilyl- oder C₁- bis C₆-Alkoxysilylgruppe stehen,
(a₃) 0 bis 20 Mol% einer oder mehrerer weiterer von (a₁) und (a₂) verschiedener olefinisch ungesättigter, copolymerisierbarer organischer Verbindungen, deren Homopolymerisate im Wellenlängenbereich zwischen 250 und 400 nm transparent sind,
mit der Maßgabe, daß die Summe der under (a₁) bis (a₃) genannten Mol-Prozentzahlen 100 ist.

Besonders bevorzugt sind solche Copolymere, welche mehr als 50 Mol% des Comonomeren der Formel (II) mit R³ = H einpolymerisiert enthalten.

Diese alkalilöslichen Polymeren (a) werden aus einem oder mehreren ungesättigten Monomeren nach gängigen Methoden radikalisch oder ionisch homo- bzw. copolymerisiert.

Als o-Nitrobenzylestermonomere (a₁) der allgemeinen Formel (I) 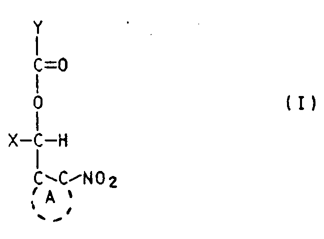
worin
- A: für ein aromatisches oder heteroaromatisches, gegebenenfalls substituiertes Ringsystem mit 5 bis 14 Ringgliedern,
- X: für Wasserstoff, einen Alkylrest mit 1 bis 8 Kohlenstoffatomen, einen gegebenenfalls substituierten Aryl- oder Aralkylrest und
- Y: für einen ethylenisch ungesättigten Rest mit 2 bis 10 Kohlenstoffatomen
stehen,
kommen beispielsweise solche in Frage, in denen der Rest Y in der allgemeinen Formel (I) für einen der Reste 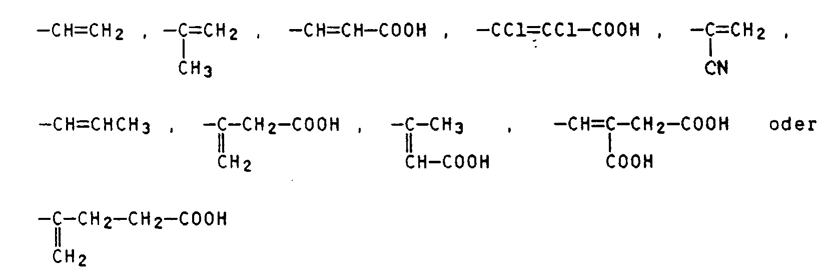
steht.

Dabei werden unter aromatischen Ringsystemen A insbesondere Benzol und substituierte Benzole verstanden. Der Benzolring kann ein- oder mehrfach substituiert sein, beispielsweise durch C₁- bis C₈-Alkyl, insbesondere Methyl, durch C₁- bis C₆-Alkoxi, insbesondere Methoxi, durch Halogen, wie Chlor, durch Nitro- oder Aminogruppen sowie durch Sulfogruppen. Es kommen auch entsprechend substituierte und unsubstituierte mehrkernige Benzolderivate, wie Naphthalin, Anthracen, Anthrachinon oder Phenanthren in Betracht. Als heteroaromatisches Ringsystem A ist insbesondere Pyridin zu nennen.

Als den o-Nitrocarbinolestergruppierungen zugrunde liegende aromatische oder heteroaromatische o-Nitrocarbinole haben sich beispielsweise die folgenden Gruppierungen besonders bewährt: o-Nitrobenzyl-, 6-Nitroveratryl-, 2-Nitro-4-aminobenzyl-, 2-Nitro-4-dimethylaminobenzyl-, 2-Nitro-4-methylaminobenzyl-, 2-Nitro-5-dimethylaminobenzyl-, 2-Nitro-5-aminobenzyl-, 2-Nitro-4,6-dimethoxibenzyl-, 2,4-Dinitrobenzyl-, 3-Methyl-2,4-dinitrobenzyl-, 2-Nitro-4-methylbenzyl-, 2,4,6-Trinitrobenzylalkohol sowie 2-Nitrobenzhydrol, 2,2′-Dinitrobenzhydrol, 2,4-Dinitrobenzhydrol oder 2,2′,4,4′-Tetranitrobenzhydrol. Ebenso geeignet sind beispielsweise 2-Nitro-3-hydroximethylnaphthalin, 1-Nitro-2-hydroximethylnaphthalin oder 1-Nitro-2-hydroximethylanthrachinon.

Den erfindungsgemäß als Komponente (a) einzusetzenden Copolymerisaten liegen, wie oben bereits ausgeführt o-Nitrocarbinolester von olefinisch ungesättigten Carbonsäuren als Monomere zugrunde, wobei als ethylenisch ungesättigte Mono- oder Dicarbonsäuren beispielsweise Acrylsäure, Methacrylsäure, Maleinsäure, Dichlormaleinsäure, Fumarsäure, Crotonsäure, Itaconsäure sowie Methylenglutarsäure verwendet werden können.

Die o-Nitrocarbinolester von olefinisch ungesättigten Carbonsäuren können nach bekannten Methoden der organischen Chemie, wie z.B. Umsetzung der Säurechloride mit o-Nitrocarbinolen oder durch direkte säurekatalyiserte Veresterung hergestellt werden.

Besonders bevorzugte o-Nitrocarbinolestermonomere sind
o-Nitrobenzyl-acrylat, o-Nitrobenzyl-methacrylat,
o-Nitro-α-methyl-benzyl-(meth)acrylat,
2-Nitro-6-chlor-α-methyl-benzyl-(meth)acrylat.

Die Copolymerisate (a) enthalten die o-Nitrocarbinolestermonomeren (a₁) im allgemeinen in einer Menge von 1 bis 40, vorzugsweise 5 bis 15 Mol.% einpolymerisiert.

Als Comonomere (a₂) enthalten die alkalilöslichen Bindemittel (a) Verbindungen der allgemeinen Formel (II) 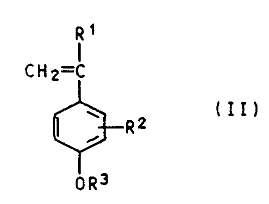
worin
- R¹: für Wasserstoff oder eine Methylgruppe,
- R²: für Wasserstoff, Halogen oder eine Alkylgruppe mit 1 bis 6 Kohlenstoffatomen,
- R³: für Wasserstoff, eine Alkylgruppe mit 1 bis 6 Kohlenstoffatomen, eine Acetyl-, Benzoyl-, C₁- bis C₆-Alkylsilyl- oder C₁- bis C₆-Alkoxysilylgruppe stehen,
einpolymerisiert.

Besonders bevorzugte O-substituierte p-Hydroxystyrolderivate sind solche, bei denen die phenolische Hydroxylgruppen verethert oder verestert ist, beispielsweise p-Methoxistyrol, p-Acetoxistyrol oder p-tert.-Butoxicarbonyloxistyrol.

Komponente (a₂) ist im erfindungsgemäßen Copolymerisat in einer Menge von 99 bis 60, vorzugsweise 95 bis 85 Mol.% einpolymerisiert.
(a₃) Die erfindungsgemäßen Copolymerisate können zur Verbesserung der Löslichkeit in wäßrig-alkalischen Lösungsmitteln oder zur Einstellung anderer Eigenschaften, wie erhöhte thermische Beständigkeit, noch eine oder mehrere von (a₁) und (a₃) verschiedene olefinisch ungesättigte, copolymerisierbare organische Verbindungen, deren Homopolymerisate im Wellenlängenbereich zwischen 250 und 400 nm transparent sind, einpolymerisiert enthalten.

Als derartige Comonomere sind beispielsweise geeignet: ethylenisch ungesättigte Carbonsäuren, wie (Meth)acrylsäure, Maleinsäure, Fumarsäure, Crotonsäure, Itaconsäure und/oder Methylenglutarsäure, andere ethylenisch ungesättige Verbindungen, wie Ethylen, Vinylaromaten, wie Styrol, Diene, wie Isopren, Butadien, Vinylamine, Vinylimine, Acrylnitril, Methacrylnitril, Vinylester, Vinylether, Vinylhalogenide, ungesättigte Anhydride, wie Maleinsäureanhydrid, ungesättigte Imide, wie N-subsitutierte Maleinsäureimide, Ester der bereits genannten olefinisch ungesättigten Carbonsäuren, wie Ester der Acryl- und insbesondere Methacrylsäure mit C₁-bis C₈-Alkoholen, vorzugsweise Methylmethacrylat sowie andere Derivate der Acrylsäure und/oder Methacrylsäure.

Die Monomeren (a₃) können in Mengen von 0 bis 20 Mol.% im erfindungsgemäßen Copolymerisat (a) einpolymerisiert sein.

Die Summe der unter (a₁) bis (a₃) genannten Molprozentzahlen in den erfindungsgemäßen Copolymeren ist 100.

Beispiele für besonders bevorzugte Copolymerisate sind solche aus o-Nitro-α-methyl-benzylmethacrylat und p-Hydroxystyrol, o-Nitro-α-methyl-benzylmethacrylat, p-Hydroxystyrol und p-Vinylanisol, o-Nitro-benzyl-acrylat und p-Hydroxystyrol, o-Nitro-benzyl-meth-acrylat, p-Hydroxystyrol und Butylacrylat sowie o-Nitro-benzyl-acrylat, p-Hydroxystyrol und Methacrylsäure.

Als organische Verbindungen (b) sind solche bevorzugt, welche mindestens eine Sulfoniumsalzgruppierung und mindestens eine t-Butylcarbonatgruppierung oder mindestens eine Silylethergruppierung enthalten. Es können jedoch auch andere Verbindungen verwandt werden, welche unter Bestrahlung eine starke Säure bilden und im gleichen Molekül eine säurespaltbare Bindung enthalten.

Besonders bevorzugte derartige organische Verbindungen (b) sind solche der allgemeinen Formel (III) 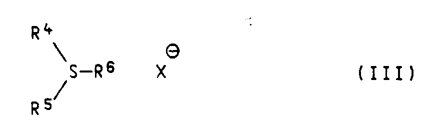
worin
R⁴, R⁵ und R⁶ untereinander gleich oder verschieden sind und für aliphatische Reste, wie z.B. Alkylgruppen mit 1 bis 12, vorzugsweise 1 bis 6 Kohlenstoffatomen, wie z.B. Methyl-, Ethyl-, n-Propyl-, i-Propyl-, n-Butyl-, i-Butyl-, tert.-Butyl-, Pentyl- oder Hexylgruppen, für cycloaliphatische Reste, wie z.B. Cyclohexyl- oder Cyclopentylgruppen, die gegebenenfalls jeweils substituiert sein können, für Arylreste, wie z.B. Phenyl- oder Naphthylreste, durch 1 bis 4 Alkylgruppen mit 1 bis 6, vorzugsweise 1 bis 4 Kohlenstoffatomen, Alkoxygruppen mit 1 bis 4, vorzugsweise 1 bis 3 Kohlenstoffatomen, ein oder zwei Halogenatome, wie z.B. Fluor, Chlor oder Brom substituierte Arylreste, wie z.B. Methyl-phenyl-, Methoxy-phenyl-, Chlorophenyl-, Brom-phenyl-, Dichlorphenyl- oder Dimethyl-phenylreste stehen oder zwei der Reste R⁴ bis R⁶ können miteinander zu einem Ring, insbesondere einem Fünf- oder Sechsring verbunden sein, wobei mindestens einer der Reste R⁴ bis R⁶ mindestens eine durch Säure spaltbare Gruppierung enthält.

Beispiele sind Sulfoniumsalze der allgemeinen Formel (III), in denen
- R⁶: z.B. für 4-t-Butoxicarbonyloxi-phenyl-, 4-t-Butoxicarbonyloxi-3,5-dimethyl-phenyl-, 4-t-Butoxicarbonyloxi-3-methyl-phenyl-, 4-t-Butoxicarbonyloxi-2-methyl-phenyl-, 4-t-Butoxicarbonyloxi-3,5-dimethoxiphenyl-, 4-t-Butoxicarbonyloxi-3,5-diphenyl-phenyl-, 4-t-Butoxicarbonyloxi-1-naphthyl-, 4-Trimethylsilyl-oxi-phenyl-, 4-Trimethylsilyl-oxi-1-naphthyl- stehen oder auch solche, in denen R⁴ und R⁵ beispielsweise zu Tetramethylengruppen verbrtickt sind und R⁶ die gleiche Bedeutung wie vorstehend hat: 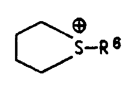
oder Verbindungen, in denen R⁴ fur Hethyl und R⁵ für Phenyl bzw. Tolyl stehen und R⁶ für ein substituiertes Phenylderivat mit säurespaltbaren Gruppen steht, wie z.B. 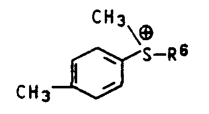
worin
- R⁶: z.B. für 4-t-Butoxicarbonyloxi-phenyl-, 2,4-Di-t-butoxicarbonyloxi-phenyl-, 4-t-Butoxicarbonyloxi-2-methoxi-phenyl-, 4-Trimethylsilyl-phenyl
steht, oder
worin
- R⁴: fur Phenyl oder C₁- bis C₁₂-substituiertes Phenyl oder halogen-substituiertes Phenyl steht und R⁵ und R⁶ substituierte Phenylderivate mit säurespaltbaren Gruppen sind, wie z.B. 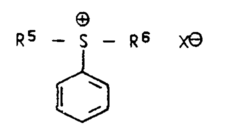
worin
- R⁵ und R⁶: z.B. 4-t-Butoxicarbonyloxi-phenyl-, 4-Trimethylsilyloxi-phenyl-, 4-t-Butyl-dimethyl-silyloxi-phenyl-, 4-t-Butoxicarbonyloxi-3,5-dimethyl-phenyl- oder
- R⁴, R⁵ und R⁶: untereinander gleich sind, d.h. Sulfoniumsalze, in denen diese Reste mit säurespaltbaren Gruppen dreimal enthalten sind.

Weiterhin kommen auch Verbindungen der allgemeinen Formel (III) in Betracht, worin einer der Reste R⁴ bis R⁶ mit einem oder mehreren weiteren Sulfoniumsalzresten, gegebenenfalls über durch Säure spaltbare Gruppierungen verknüpft ist, die also ebenfalls mehrere Sulfoniumgruppen im Molekül aufweisen, wie z.B. 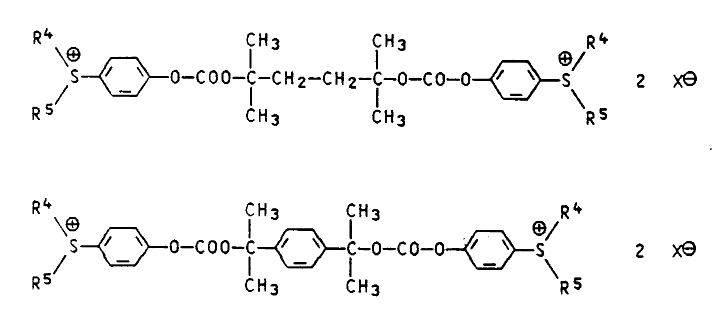
Weitere Beispiele für erfindungsgemäß einzusetzende Sulfoniumsalze sind nachfolgend aufgeführt: 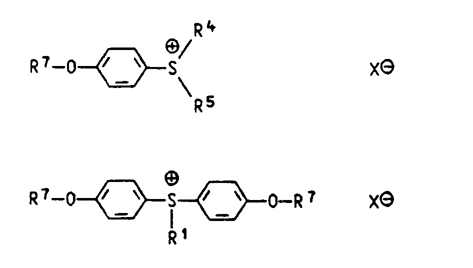 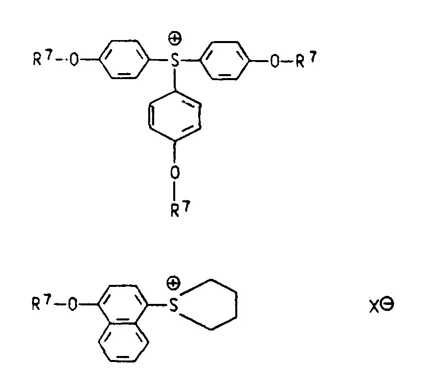
worin X^{⊖} Halogen, bevorzugt jedoch komplexe Anionen wie BF₄^{⊖}, AsF₆^{⊖}, SbF₆^{⊖}, PF₆^{⊖} bedeuten kann;
R⁴ und R⁵ wie oben angegeben, Alkyl-, Aryl- oder subst. Arylgruppen bedeuten oder miteinander zu einem Ring verknüpft sind (d.h. bivalent z.B. tetramethylen);
R⁷ bedeutet t-Butoxicarbonyl- oder Trialkylsilylreste, wie z.B. Trimethylsilyl- oder t-Butyl-dimethylsilylgruppen.

Die Sulfoniumsalze können nach üblichen Methoden der organischen Chemie zur Synthese von Estern, Carbonaten und Ethern hergestellt werden, indem man von bekannten Sulfoniumsalzen mit phenolischen Gruppen ausgeht und diese so umsetzt, daß t-Butylester, t-Butylcarbonate oder Silylether von Phenolen entstehen.

Beispiele für bevorzugte Sulfoniumsalze sind Dimethyl-4-t-butoxicarbonyloxiphenyl-sulfoniumsalz mit Hexafluoroarsenat, Hexafluoroantimonat, Hexafluorophosphat und/oder Hexafluoroborat als Gegenion, Phenyl-bis-(4-t-butoxicarbonyloxiphenyl-)sulfoniumsalz mit den genannten Gegenionen, Tris-(4-t-butoxicarbonyloxiphenyl-)sulfoniumsalz mit den genannten Gegenionen oder 1-Naphthyl-4-trimethylsilyloxitetramethylen-sulfoniumsalz mit den genannten Gegenionen.

Die erfindungsgemäßen strahlungsempfindlichen Gemische sind sensitiv gegenüber Röntgen-, Elektronen- und UV-Strahlung. Gegebenenfalls können Sensibilisatoren in geringen Mengen zugesetzt werden, wie beispielsweise Pyren und Perylen, um die Verbindungen im längerwelligen UV- bis hin zum sichtbaren Wellenlängenbereich zu sensibilisieren.

### Verfahren zur Herstellung von Reliefmustern

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig mit solcher Dosis bestrahlt, daß die Löslichkeit der belichteten Bereiche nach einem thermischen Ausheizschritt bei Temperaturen zwischen 60 und 120°C in wäßrig-alkalischen Lösungsmitteln zunimmt und diese Bereiche selektiv mit dem alkalischen Entwickler entfernt werden können.

Vorzugsweise wird z.B. das polymere Bindemittel (a), welches zwischen 1 und 40 Mol% Monomerkomponente (a₁) und zwischen 99 und 60 Mol% Monomerkomponente (a₂) einpolymerisiert enthält, sowie 2 bis 20 Gew.%, besonders bevorzugt zwischen 5 und 15 Gew.% einer Verbindung des Typs (b), bezogen auf das Gesamtgewicht der Verbindungen (a) und (b), in Methylglykolacetat oder Methyl-propylenglykol-acetat gelöst, wobei der Feststoffgehalt zwischen 10 und 30 Gew.% betragen kann. Die Lösung kann durch ein Filter mit einem Porendurchmesser von 0.2 µm filtriert werden. Durch Aufschleudern der Resistlösung bei Umdrehungszahlen zwischen 1000 und 10000 U/min auf einen Wafer wird ein Resistfilm auf dem Wafer erzeugt. Der Wafer wird anschließend zwischen 1 und 5 Minuten bei 90°C bzw. 80°C ausgeheizt. Die Filme werden dann durch eine chrombeschichtete strukturierte Quarzmaske mit UV-Licht einer Quecksilberlampe, mit Excimer-Laserlicht, Elektronen- oder Röntgenstrahlen bestrahlt. Die bestrahlten Filme werden zwischen 5 Sekunden und 2 Minuten bei Temperaturen zwischen 60 und 120°C ausgeheizt. Die so behandelten Filme werden hierauf mit alkalischen oder alkoholischen Entwicklern entwickelt, wobei sich die belichteten Bereiche selektiv ablösen, während in den unbelichteten Bereichen kein oder nur geringer Abtrag stattfindet.

Das erfindungsgemäße strahlungsempfindliche Gemisch zeichnet sich gegenüber den Gemischen gemäß dem Stand der Technik dadurch aus, daß mit dem erfindungsgemäßen Zweikomponentensystem auf Basis eines alkalilöslichen Bindemittels und einer löslichkeitsinhibierenden Sulfoniumverbindung Resistmuster guter Strukturqualität erhalten werden, wenn man die Resistmuster nach dem üblichen Verfahren herstellt, und vorzugsweise zusätzlich nach der Belichtung auf Temperaturen von 60°C bis 120°C erhitzt.

Die damit erhältlichen positiv arbeitenden Photoresiste weisen deutliche Vorteile hinsichtlich Photoempfindlichkeit im kurzwelligen UV-Bereich (bevorzugt bei 248 nm) und Qualität der erzeugbaren Resiststrukturen auf.

Die in den Beispielen und Vergleichsbeispielen genannten Teile und Prozente sind, soweit nicht anders angegeben, Gewichtsteile und Gewichtsprozente.

### Beispiel 1

Eine Fotoresistlösung wird aus 10 Teilen Tris-(4-t-butoxicarbonyloxiphenyl-)sulfoniumhexafluoroarsenat, 90 Teilen eines Copolymeren aus 90 Mol% p-Hydroxystyrol und 10 Mol% o-Nitro-(α)-methyl-benzylmethacrylat in 400 Teilen Methylpropylen-glykol-acetat hergestellt. Die Lösung wird durch ein Filter mit einem Porendurchmesser von 0,2 µm filtriert. Die Resistlösung wird auf einen Siliziumwafer mit einem SiO₂-Film in einer Schichtdicke von ca. 1,0 µm aufgeschleudert. Die optische Dichte dieser Schicht bei 248 nm beträgt 0,55. Der Wafer wird eine Minute bei 90°C getrocknet, anschließend mit einer bildmäßig strukturierten Testmaske in Kontakt gebracht und 5 Sekunden mit Excimer-Laserlicht der Wellenlänge 248 nm belichtet. Danach wird 60 Sekunden bei 80°C ausgeheizt und mit einem Entwickler vom pH-Wert 13,00 60 Sekunden entwickelt. Die belichteten Bereiche sind vollständig abgetragen, während kein Abtrag der unbelichteten Bereiche gemessen wird. Die Resistmuster zeigen vertikale Flanken.

### Vergleichsbeispiel 1 (Resistformulierung ohne Sulfoniumsalz)

Eine Fotoresistlösung wird aus einem Copolymeren aus 78 Mol% p-Hydroxystyrol und 22 Mol% o-Nitro-(α)-methyl-benzylmethacrylat in Methylpropylenglykol-acetat hergestellt, filtriert und mit einer Schichtdicke von 1 µm auf einen Siliziumwafer mit einem SiO₂-Film aufgeschleudert. Die optische Dichte dieser Schicht beträgt 0,54. Nach dem Ausheizen während einer Minute bei 90°C wird die Schicht mit einer bildmäßig strukturierten Testmaske in Kontakt gebracht und mit Excimer-Laserlicht der Wellenlänge 248 nm belichtet. Um die belichteten Bereiche mit einem Entwickler von pH 13,00 während 60 Sekunden vollständig abzutragen, mußte der Film 30 Sekunden belichtet werden.

### Vergleichsbeispiel 2 (Bindemittel ohne o-Nitrobenzylgruppen)

Eine Fotoresistlösung wird aus 10 Teilen Tris-(4-t-butoxicarbonyloxiphenyl-)sulfoniumhexafluoroarsenat, 90 Teilen Poly-(p-hydroxystyrol) und 400 Teilen Methyl-propylen-glykol-acetat hergestellt. Die Lösung wird anschließend durch ein Filter mit einem Porendurchmesser von 0,2 µm filtriert. Die Resistlösung wird auf einen Siliziumwafer mit einem SiO₂-Film in einer Schichtdicke von 1,0 µm aufgeschleudert. Der Wafer wird eine Minute bei 90°C getrocknet und anschließend mit einer bildmäßig strukturierten Testmaske in Kontakt gebracht und 3 Sekunden mit Excimer-Laserlicht der Wellenlänge 248 nm belichtet. Danach wird 60 Sekunden bei 80°C ausgeheizt. Wird mit einem Entwickler vom pH-Wert 13,00 60 Sekunden entwickelt, wie in Beispiel 1, so werden die belichteten Bereiche zwar vollständig entfernt, der Abtrag in den unbelichteten Bereichen ist jedoch zu hoch (58%).

## Patentansprüche

1. Strahlungsempfindliches Gemisch, enthaltend
(a) ein in Wasser unlösliches, in wäßrig-alkalischen Lösungen lösliches polymeres Bindemittel und
(b) eine organische Verbindung, deren Löslichkeit in einem wäßrigalkalischen Entwickler durch Einwirkung von Säure erhöht wird und die mindestens eine durch Säure spaltbare Gruppierung enthält, dadurch gekennzeichnet, daß das polymere Bindemittel (a) ein Copolymerisat ist, welches o-Nitrobenzylgruppierungen enthält.

2. Strahlungsempfindliches Gemisch nach Anspruch 1, dadurch gekennzeichnet, daß das in Wasser unlösliche, in wäßrig alkalischen Lösungen jedoch lösliche polymere Bindemittel (a) ein Copolymerisat ist, welches einpolymerisiert enthält
(a₁) 1 bis 40 Mol% mindestens einer Verbindung der allgemeinen Formel (I) 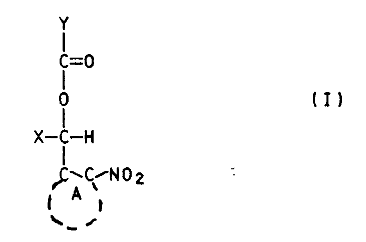 worin
A für ein aromatisches oder heteroaromatisches, gegebenenfalls substituiertes Ringsystem mit 5 bis 14 Ringgliedern,
X für Wasserstoff, einen Alkylrest mit 1 bis 8 Kohlenstoffatomen, einen gegebenenfalls substituierten Aryl- oder Aralkylrest und
Y für einen ethylenisch ungesättigten Rest mit 2 bis 10 Kohlenstoffatomen
stehen,
(a₂) 99 bis 60 Mol% mindestens einer Verbindung der allgemeinen Formel (II) 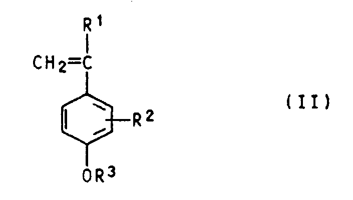 worin
R¹ für Wasserstoff oder eine Methylgruppe,
R² für Wasserstoff, Halogen oder eine Alkylgruppe mit 1 bis 6 Kohlenstoffatomen,
R³ für Wasserstoff, eine Alkylgruppe mit 1 bis 6 Kohlenstoffatomen, eine Acetyl-, Benzoyl-, C₁- bis C₆-Alkylsilyl- oder C₁- bis C₆-Alkoxysilylgruppe
stehen,
(a₃) 0 bis 20 Mol% einer oder mehrerer weiterer von (a₁) und (a₂) verschiedener olefinisch ungesättigter, copolymerisierbarer organischer Verbindungen, deren Homopolymerisate im Wellenlängenbereich zwischen 250 und 400 nm transparent sind, mit der Maßgabe, daß die Summe der under (a₁) bis (a₃) genannten Mol-Prozentzahlen 100 ist.

3. Strahlungsempfindliches Gemisch nach einem der vorhergehenden Ansprüche, dadurch gekennzeichnet, daß es als Komponente (b) ein oder mehrere Sulfoniumsalze der allgemeinen Formel (III) 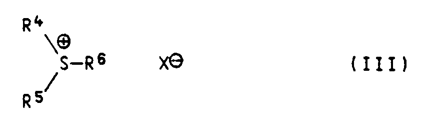 worin R⁴, R⁵ und R⁶ untereinander gleich oder verschieden sind und für aliphatische und/oder aromatische Reste, die gegebenenfalls Heteroatome enthalten, stehen oder zwei der Reste R⁴ bis R⁶ miteinander zu einem Ring verknüpft sind, mit der Maßgabe, daß mindestens einer der Reste R⁴ bis R⁶ mindestens eine durch Säure spaltbare Gruppierung enthält, wobei einer der Reste R⁴ bis R⁶ mit einem oder mehreren weiteren Sulfoniumsalzresten, gegebenenfalls über durch Säure spaltbare Gruppierungen, verknüpft sein kann, und X^{⊖} ein nichtnukleophiles Gegenion bedeutet, enthält.

4. Verfahren zur Herstellung von Reliefmustern und Reliefbildern, dadurch gekennzeichnet, daß man als lichtempfindliche Beschichtungsmaterialien strahlungsempfindliche Gemische nach einem der Ansprüche 1 bis 3 verwendet.

5. Verfahren zur Herstellung von Reliefmustern nach Anspruch 4, dadurch gekennzeichnet, daß nach der Belichtung auf Temperaturen zwischen 60 und 120°C erhitzt wird.

## Claims

1. A radiation-sensitive mixture containing
(a) a polymeric binder which is insoluble in water but soluble in aqueous alkaline solutions and
(b) an organic compound whose solubility in an aqueous alkaline developer is increased by the action of an acid and which contains one or more acid-cleavable groups,
wherein the polymeric binder (a) is a copolymer which contains o-nitrobenzyl groups.

2. A radiation-sensitive mixture as claimed in claim 1, wherein the polymeric binder (a) which is insoluble in water but soluble in agueous alkaline solutions is a copolymer which contains, as copolymerized units,
(a₁) from 1 to 40 mol % of one or more compounds of the formula (I) 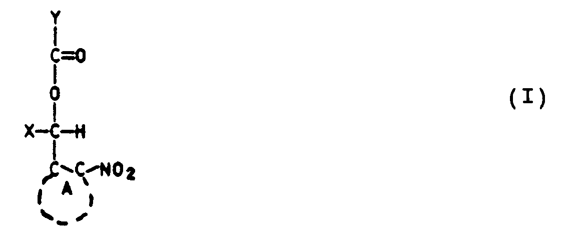 where A is an aromatic or heteroaromatic, unsubstituted or substituted ring system having 5 to 14 ring members, X is hydrogen, alkyl of 1 to 8 carbon atoms or unsubstituted or substituted aryl or aralkyl and Y is an ethylenically unsaturated radical of 2 to 10 carbon atoms,
(a₂) from 99 to 60 mol % of one or more compounds of the formula (II) 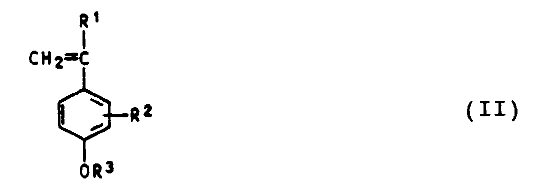 where R¹ is hydrogen or methyl, R² is hydrogen, halogen or alkyl of 1 to 6 carbon atoms and R³ is hydrogen, alkyl of 1 to 6 carbon atoms, acetyl, benzoyl, C₁-C₆-alkylsilyl or C₁-C₆-alkoxysilyl, and
(a₃) from 0 to 20 mol % of one or more further olefinically unsaturated, copolymerizable organic compounds which differ from (a₁) and (a₂) and whose homopolymers are transparent in the wavelength range from 250 to 400 nm,
with the proviso that the sum of the molar percentages stated under (a₁) to (a₃) is 100.

3. A radiation-sensitive mixture as claimed in any of the preceding claims, which contains, as component (b), one or more sulfon-ium salts of the formula (III) 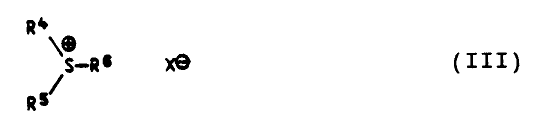 where R⁴, R⁵ and R⁶ are identical or different and are aliphatic and/or aromatic radicals which may contain heteroatoms, or two of the radicals R⁴ to R⁶ are bonded to one another to form a ring, with the proviso that one or more of the radicals R⁴ to R⁶ contain one or more acid-cleavable groups, and one of the radicals R⁴ to R⁶ may be bonded to one or more further sulfonium salt radicals, if necessary via acid-cleavable groups, and X^{⊖} is a nonnucleophilic counter-ion.

4. A process for the production of relief patterns and relief images, wherein a radiation-sensitive mixture as claimed in any of claims 1 to 3 is used as the photosensitive coat-ing material.

5. A process for the production of relief patterns as claimed in claim 4, wherein, after exposure, heating is carried out at from 60 to 120°C.

## Revendications

1. Mélange sensible aux rayonnements, contenant
(a) un liant polymère insoluble dans l'eau mais soluble dans les solutions aqueuses alcalines et
(b) un composé organique dont la solubilité dans un révélateur aqueux-alcalin est accrue sous l'action d'un acide et qui contient au moins un groupement scindable sous l'action d'un acide,
caractérisé en ce que le liant polymère (a) est un copolymère contenant des groupements o-nitrobenzyle.

2. Mélange sensible aux rayonnements selon la revendication 1 caractérisé en ce que le liant polymère (a) insoluble dans l'eau, mais soluble dans les solutions aqueuses alcalines, est un copolymère contenant, à l'état polymérisé,
(a1) 1 à 40 mol % d'au moins un composé de formule générale I 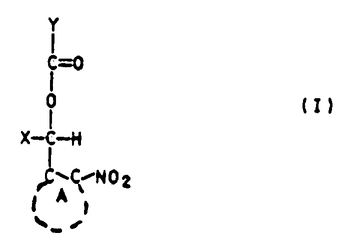 dans laquelle
A représente un système cyclique aromatique ou hétéroaromatique éventuellement substitué, comprenant 5 à 14 chaînons cycliques,
X représente l'hydrogène, un groupe alkyle en C1-C8, un groupe aryle ou aralkyle éventuellement substitué et
Y représente un radical à insaturation éthylénique en C2-C10,
(a2) 99 à 60 mol % d'au moins un composé de formule générale I 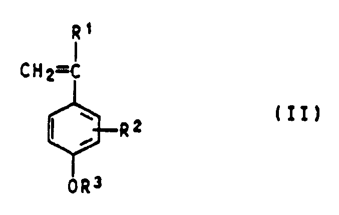 dans laquelle
R¹ représente l'hydrogène ou un groupe méthyle,
R² représente l'hydrogène, un halogène ou un groupe alkyle en C1-C6,
R³ représente l'hydrogène, un groupe alkyle en C1-C6, un groupe acétyle, benzoyle, (alkyle en C1-C6)-silyle ou (alcoxy en C1-C6)-silyle,
(a3) 0 à 20 mol % d'un ou plusieurs autres composés organiques à insaturation oléfinique copolymérisables, différents de (a1) et (a2), dont les homopolymères sont transparents dans l'intervalle des longueurs d'onde de 250 à 400 nm,
la somme des pourcentages molaires indiqués pour (a1) à (a3) étant égale à 100.

3. Mélange sensible aux rayonnements selon une des revendications qui précèdent caractérisé en ce qu'il contient en tant que composant (b) un ou plusieurs sels de sulfonium de formule générale III 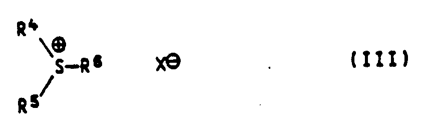 dans laquelle R⁴, R⁵ et R⁶, ayant des significations identiques ou différentes, représentent des radicaux aliphatiques et/ou aromatiques contenant le cas échéant des hétéroatomes, ou bien deux des groupes R⁴ à R⁶ sont reliés entre eux avec formation d'un cycle, sous réserve que l'un au moins des groupes R⁴ à R⁶ contient au moins un groupement scindable sous l'action d'un acide, l'un des groupes R⁴ à R⁶ pouvant être relié avec un ou plusieurs autres radicaux de sels de sulfonium, éventuellement par l'intermédiaire de groupements scindables sous l'action d'un acide, et X^{⊖} représente un ion complémentaire non-nucléophile.

4. Procédé pour la fabrication de modèles en relief et d'images en relief, caractérisé en ce que l'on utilise en tant que matériaux de revêtement photosensibles des mélanges sensibles aux rayonnements selon l'une des revendications 1 à 3.

5. Procédé pour la fabrication de modèles en relief selon la revendication 4, caractérisé en ce que, après exposition à la lumière, on chauffe à des températures de 60 à 120 degrés C.
